# EUROPÄISCHE PATENTANMELDUNG

(11) **EP 1 118 927 A1**
(43) Veröffentlichungstag der Anmeldung: **25.07.2001**
(21) Anmeldenummer: 00440330.9
(22) Anmeldetag: 15.12.2000
(51) Int. Cl.: G06F 1/18, H05K 7/14

(54) **Vorrichtung zur Nachrüstung eines Computers**

(30) Priorität: 18.01.2000 DE 10001815
(71) Anmelder: ALCATEL, 75008 Paris (FR)
(72) Erfinder: Schmidt, Hartmut, 71723 Grossbottwar (DE); Custers, Stefan, 2260 Westerlo (BE)
(74) Vertreter: Giebel-Roder, Marion

(57) **Zusammenfassung**

Die Erfindung betrifft eine Vorrichtung zur Nachrüstung eines Computers mit kommerziellen Einschüben (1) wobei der Computer mit Einschubschlitzen versehen ist, deren Format nicht mit dem der kommerziellen Einschübe (1) übereinstimmt. Eine derartige Nachrüstungsvorrichtung ist dadurch gekennzeichnet, dass ein Trägereinschub (2) mit einer randoffenen Aussparung zur Aufnahme des kommerziellen Einschubes (1) vorgesehen ist, wobei der Trägereinschub (2) Interface-Mittel (3 und 5) zur Anpassung der Ein- und Ausgänge des Einschubes (1) an die Ein- und Ausgänge des Einschubschlitzes aufweist und die Einschub/Trägereinschub-Baugruppe mit dem Format des Einschubschlitzes im Wesentlichen übereinstimmt.

## Beschreibung

Die Erfindung betrifft eine Vorrichtung zur Nachrüstung eines Computers mit kommerziellen Einschüben, wobei der Computer mit Einschubschlitzen versehen ist, deren Format nicht mit dem der kommerziellen Einschübe übereinstimmt. Im Zuge der fortschreitenden Entwicklung der Computertechnik kommt es immer häufiger zu Kompatibilitätsschwierigkeiten im Hinblick auf nachzurüstende Hardware-und/oder Software-Module. Die dazu vorgesehenen Einschubschlitze der vorhandenen Computer stimmen mit ihren Interfaceanschlüssen und/oder äußeren Abmessungen nicht mehr mit den Anschlussbedingungen kommerziellen Einschübe überein. Ältere, aber dennoch leistungsfähige und für ihren Verwendungszweck hervorragend geeignete Computer, beispielsweise im Telekommunikationsbereich, sind nicht mehr mit größeren Speichern, aktualisierten Softwareversionen und anderen Applikationen nachrüstbar. Moderne Standard-Bus-Systeme und Formate wie VME oder Compact PCI lassen sich nicht in vorhandene Computersysteme integrieren. Die neue Einschubgeneration des COTS-Formats (Commercial off the shelf) zeichnet sich durch verkleinerte Bauform und verändertes Interface aus.

Der Erfindung liegt die Aufgabe zugrunde, eine Nachrüstungsvorrichtung der gattungsgemäßen Art anzugeben, die es gestattet, dass vorgegebene Computereinschubschlitze mit Einschüben bestückt werden können, deren Format und Interface nicht mit dem der Schlitze übereinstimmt.

Erfindungsgemäß wird die Aufgabe dadurch gelöst, dass ein Trägereinschub mit einer randoffenen Aussparung zur Aufnahme des kommerziellen Einschubes vorgesehen ist, wobei der Trägereinschub Interface-Mittel zur Anpassung der Ein- und Ausgänge des Einschubes an die Ein- und Ausgänge des Einschubschlitzes aufweist und die Einschub/Trägereinschub-Baugruppe mit dem Format des Einschubschlitzes im Wesentlichen übereinstimmt. Auf diese Weise wird eine mechanische und Interface-Anpassung zwischen vorgegebenem Computereinschubschlitz und kommerziellem Einschub erreicht. Um vorhandene Computer mit Einschüben anderer Formate und Interfaces nachrüsten zu können, werden Trägereinschübe zwischengesetzt. Der neue Einschub wird vorzugsweise mittig in den im Wesentlichen U-förmigen Trägereinschub montiert. Dabei wird der Einschub in eine Aussparung des Trägereinschubes eingesetzt, wobei sich glatte, stufenlose Seitenflächen der Einschub/Trägereinschub-Baugruppe ergeben. Für die Einschub/Trägereinschub-Baugruppe ist nur ein Computereinschubschlitz erforderlich. Leistungsfähigere beziehungsweise völlig neue Software lässt sich somit leicht nachrüsten, wobei der Trägereinschub wieder benutzbar für andere Einschübe ist, die noch bessere Software oder neue beziehungsweise verbesserte Applikationen beinhalten. Die Lebensdauer technisch aufwendiger und sehr teurer Grundsysteme lässt sich durch die einfache Nachrüstbarkeit mit den modernsten peripheren Modulen erheblich verlängern. Außerdem wird dadurch auch die Markteinführung neuer Standards bezüglich des Formats und des Interfaces von Computereinschüben wesentlich erleichtert.

Die Erfindung wird nachfolgend anhand eines figürlich dargestellten Ausführungsbeispiels näher erläutert.

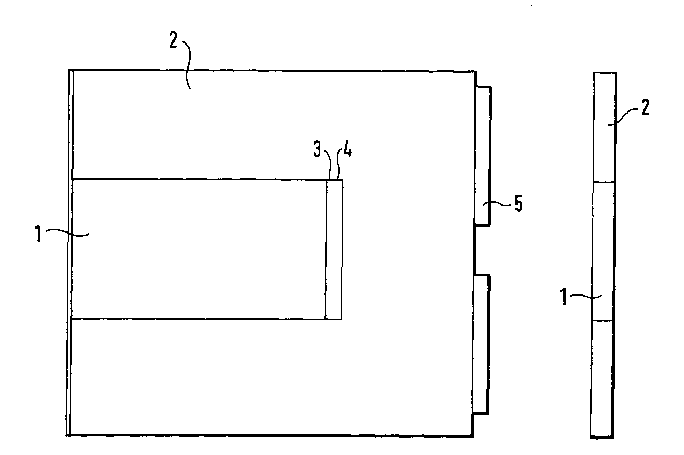

Die Figur zeigt eine schematisierte Darstellung einer Einschub/Trägereinschub-Baugruppe in Seitenansicht und in Stirnansicht. Ein standardisierter COTS - Commercial off the Shelf - Einschub 1 ist dabei einrastend in einen Trägereinschub 2 eingesetzt. Der im Wesentlichen U-förmige Trägereinschub 2 ist im Inneren seiner Einschuböffnung mit Interface-Mitteln 3 ausgestattet, die mit dem Standard-Bus-Interface 4 des COTS-Einschubes 1 korrespondieren. Über ein Daten-Bus-System oder andere adaptive Elemente sind die Interface-Mittel 3 des Trägereinschubes 2 mit einem Bus-Interface 5 an der einem Einschubschlitz eines Computers zugewandten peripheren Seiten des Trägereinschubes 2 verbunden. Dieser Bus-Interface 5 wiederum korrespondiert mit dem Einschubschlitz-Interface. Die Softwaredaten oder die Applikationen, die der COTS-Einschub 1 enthält, sind somit auch für Computer mit Einschubschlitzen älterer Bauart verwendbar. Die mechanische Anpassung der äußeren Abmessungen kann durch die Bauform des Trägereinschubes 2 derart getroffen sein, dass sich glatte, quasi stufenlose Seitenflächen der Einschub/Trägereinschub-Baugruppe ergeben. Dabei können auch Dickenunterschiede durch eine taschenförmige Einschuböffnung des Trägereinschubes 2 ausgeglichen sein. Die Einschub/Trägereinschub-Baugruppe kann als Kompakt-Nachrüsteinheit ausgebildet sein. Möglich ist aber auch eine zweiteilige Ausführungsform, bei der ein Trägereinschub 2 seitens des Computerbenutzers mit verschiedenen COTS-Einschüben 1 je nach Bedarf bestückbar ist.

Die Erfindung beschränkt sich nicht auf das vorstehend angegebene Ausführungsbeispiel. Vielmehr ist eine Anzahl von Varianten denkbar, welche auch bei grundsätzlich anders gearteter Ausführung von den Merkmalen der Erfindung Gebrauch machen.

## Patentansprüche

1. Vorrichtung zur Nachrüstung eines Computers mit kommerziellen Einschüben (1), wobei der Computer mit Einschubschlitzen versehn ist, deren Format nicht mit dem der kommerziellen Einschübe (1) übereinstimmt, dadurch gekennzeichnet, dass ein Trägereinschub (2) mit einer randoffenen Aussparung zur Aufnahme des kommerziellen Einschubes (1) vorgesehen ist, wobei der Trägereinschub (2) Interface-Mittel (3 und 5) zur Anpassung der Ein- und Ausgänge des Einschubes (1) an die Ein- und Ausgänge des Einschubschlitzes aufweist und die Einschub/Trägereinschub-Baugruppe mit dem Format des Einschubschlitzes im Wesentlichen übereinstimmt.
